# EUROPEAN PATENT APPLICATION

(11) **EP 4 697 045 A1**
(43) Date of publication of application: **18.02.2026**
(21) Application number: 24306360.9
(22) Date of filing: 14.08.2024
(51) Int. Cl.: G01R 31/396, H01M 10/48, H04Q 9/00, H01M 10/42

(54) **BATTERY MANAGEMENT SYSTEM**

(71) Applicant: NXP USA, Inc., Austin TX 78735 (US)
(72) Inventor: Beaulaton, Hugues, 31023 Toulouse Cedex 1 (FR); Görgen, Ralph, 5656 AG Eindhoven (NL); Desposito, Domenico, 31023 Toulouse Cedex 1 (FR); Brule, Simon, 31023 Toulouse Cedex 1 (FR); Steinfatt, Ole, 5656 AG Eindhoven (NL); Paul, Carl-Hinrich, 5656 AG Eindhoven (NL)
(74) Representative: Schmütz, Christian Klaus Johannes

(57) **Abstract**

A battery management system comprising: a synchronisation element comprising an oscillator wherein the synchronisation element is configured to generate a reference clock signal based on an output of the oscillator; and a plurality of measurement devices wherein each measurement device is configured to measure an electrical property of one or more battery cells and comprises a local oscillator configured to generate an individual clock signal; and wherein the plurality of measurement devices are connected in a communication network with the synchronisation element, and wherein: the synchronisation element is configured to send, by the communication network, time reference signals to the plurality of measurement devices based on the reference clock signal; each measurement device is configured to compare each time reference signal to its individual clock signal and, based on any detected difference, adjust its local oscillator to synchronize the individual clock signal with the reference clock signal.

## Description

### Field

The present disclosure relates to a battery management system configured to provide synchronization between a synchronization element and a plurality of measurement devices that are configured to measure electrical properties of one or more battery cells. In particular, the disclosure relates to a battery management system configured to provide said synchronization and make an electrochemical impedance measurement. It also relates to a corresponding method.

### Background

A Battery Management System (BMS) provides measurement and other functions for a battery pack comprising one or more battery cells. It is common for battery cells inside a battery pack to be continuously monitored during charge and discharge by the battery management system. Spectral impedance measurement is recognized to be an efficient technique to derive battery cell temperature, state of charge (SoC) and state of health (SoH). The technique comprises providing an excitation signal, comprising a voltage and/or current, to the battery cells and measuring the reaction of the battery cells to the excitation signal by monitoring the change(s) in voltage of the battery cells over time and/or the change in current over time. A complex impedance is determined which can be used to derive the battery temperature, SoC and SoH as will be known to those skilled in the art.

An accurate electrochemical impedance measurement requires a synchronous system, across all component devices or integrated circuits of the BMS. However, BMS ICs are typically scattered over the battery pack and they are connected via a daisy chain communication bus or wireless protocol, preventing the distribution of a common clock. Synchronization therefore presents a challenge.

### Summary

According to a first aspect of the present disclosure there is provided a battery management system comprising:
a synchronisation element comprising an oscillator wherein the synchronisation element is configured to generate a reference clock signal based on an output of the oscillator; and
a plurality of measurement devices wherein each measurement device is configured to measure an electrical property of one or more battery cells and comprises a local oscillator configured to generate an individual clock signal; and
wherein the plurality of measurement devices are connected in a communication network with the synchronisation element, and wherein:
the synchronisation element is configured to send, by the communication network, time reference signals to the plurality of measurement devices based on the reference clock signal;
each measurement device is configured to compare each time reference signal to its individual clock signal and, based on any detected difference, adjust its local oscillator to synchronize the individual clock signal with the reference clock signal.

In one or more examples, the plurality of measurement devices are connected in a daisy-chain to form the communication network with the synchronisation element. In other examples, the communication network may be wireless and/or have a star topology.

In one or more embodiments, the synchronisation element is configured to, prior to sending each of the time reference signals to the plurality of measurement devices, determine whether the communication network is busy or free for sending the time reference signal, and
if the communication network is free, send the time reference signal based on the reference clock signal;
if the communication network is busy, send the time reference signal at a later time based on the reference clock signal at the later time.

In one or more embodiments, the synchronisation element is configured to, prior to sending each of the time reference signals to the plurality of measurement devices, determine whether the communication network is busy or free for sending the time reference signal, and
if the communication network is busy, wait until the communication network is free and send the time reference signal based on the reference clock signal at the time the communication network becomes free.

In one or more embodiments, the synchronisation element comprises a counter configured to one of increment or decrement a value based on the reference clock signal and wherein each time reference signal is based on the current value of the counter.

In one or more embodiments, the plurality of measurement devices are configured to, following said synchronization of the individual clock signal of each of the measurement devices with the reference clock signal, measure the voltage of the battery cells for an electrochemical impedance measurement.

In one or more embodiments, the system comprises a microcontroller communicatively coupled with a gateway master device, wherein the gateway master device comprises part of the communication network with the plurality of measurement devices.

In one or more embodiments, the synchronisation element comprises part of the gateway master device.

In one or more embodiments, the plurality of measurement devices and the gateway master device are configured to communicate over the communication network using a first protocol and wherein the time reference signals are sent using the first protocol.

In one or more embodiments, the controller is configured to provide a periodic trigger signal to the synchronisation element to initiate the sending of one of the time reference signals; and
wherein the synchronisation element is configured to, in response to receipt of the trigger signal, and prior to sending each of the time reference signals to the plurality of measurement devices, determine whether the communication network is busy or free for sending the time reference signal; and
if the communication network is busy, wait until the communication network is free and send the time reference signal based on the reference clock signal at the time the communication network becomes free.

In one or more embodiments, the synchronisation element comprises part of the microcontroller.

In one or more embodiments, each of the local oscillators comprises a frequency locked loop.

In one or more embodiments, the local oscillator of each of the plurality of measurement devices comprises a voltage-controlled oscillator and each of the plurality of measurement devices comprise:
a synchronisation loop comprising a comparator, a local counter configured to one of increment or decrement a respective second value based on an output of the local oscillator, and a proportional-integral controller, wherein the comparator is configured to compare the output of the local counter to the counter value indicated by the time reference signal and the proportional-integral controller is configured to, based on any detected difference, control the voltage provided to the voltage-controlled oscillator to adjust a frequency of the output of the voltage-controlled oscillator, the synchronisation loop configured to cause the frequency of the voltage-controlled oscillator to converge towards the frequency of the oscillator of the synchronisation element.

In one or more embodiments, the plurality of measurement devices comprise one or both of:
a plurality of battery cell controllers configured to measure a voltage of one or more battery cells; and
a battery junction box measurement system configured to measure a current flow through one or more battery cells.

In one or more embodiments, the communication network is configured to galvanically isolate the plurality of measurement devices from one another.

According to a second aspect of the disclosure there is provided a method for controlling a battery management system, the battery management system comprising a synchronisation element comprising an oscillator wherein the synchronisation element is configured to generate a reference clock signal based on an output of the oscillator; and a plurality of measurement devices wherein each measurement device is configured to measure an electrical property of one or more battery cells and comprises a local oscillator configured to generate an individual clock signal; and wherein the plurality of measurement devices are connected to form a communication network with the synchronisation element, and wherein the method comprises:
sending, by the synchronisation element, time reference signals to the plurality of measurement devices based on the reference clock signal;
comparing, by each measurement device, each time reference signal to the individual clock signal; and
adjusting, based on any detected difference, by each measurement device, its local oscillator to synchronize the individual clock signal with the reference clock signal.

While the disclosure is amenable to various modifications and alternative forms, specifics thereof have been shown by way of example in the drawings and will be described in detail. It should be understood, however, that other embodiments, beyond the particular embodiments described, are possible as well. All modifications, equivalents, and alternative embodiments falling within the spirit and scope of the appended claims are covered as well.

In one or more embodiments, the method comprises the synchronisation element, prior to sending each of the time reference signals to the plurality of measurement devices, determining whether the communication network is busy or free for sending the time reference signal, and
if the communication network is free, sending the time reference signal based on the reference clock signal;
if the communication network is busy, sending the time reference signal at a later time based on the reference clock signal at the later time.

In one or more embodiments, the method comprises the synchronisation element, prior to sending each of the time reference signals to the plurality of measurement devices, determining whether the communication network is busy or free for sending the time reference signal, and
if the communication network is busy, waiting until the communication network is free and sending the time reference signal based on the reference clock signal at the time the communication network becomes free.

In one or more embodiments, the synchronisation element comprises a counter configured to one of increment or decrement a value based on the reference clock signal and wherein the method comprises the sending the time reference signal based on a current value of the counter.

The above discussion is not intended to represent every example embodiment or every implementation within the scope of the current or future Claim sets. The figures and Detailed Description that follow also exemplify various example embodiments. Various example embodiments may be more completely understood in consideration of the following Detailed Description in connection with the accompanying Drawings.

### Brief Description of the Drawings

One or more embodiments will now be described by way of example only with reference to the accompanying drawings in which:
Figure 1 shows an example embodiment of a battery management system;
Figure 2 shows an example embodiment of the synchronization functionality described herein integrated in the battery management system;
Figure 3 shows a timing diagram illustrating an example operation of the synchronization element;
Figure 4 shows a first and a second flowchart illustrating the operation of the synchronization element and each of the plurality of measurement devices; and
Figure 5 shows two example graphs illustrating the converging of the frequency of a local oscillator with the oscillator of the synchronization element and the converging of the value of respective counters.

### Detailed Description

The examples described herein allow for synchronisation between nodes of a communication network of a battery management system. The nodes may comprise circuitry for monitoring one or more battery cells, such as different cells or groups of cells. The monitoring may comprise measuring the voltage across one or more cells and/or the current flow through one or more cells. The synchronisation of clocks or oscillators local to the nodes to a master clock or oscillator may be advantageous when making measurements, such as electrochemical impedance measurements.

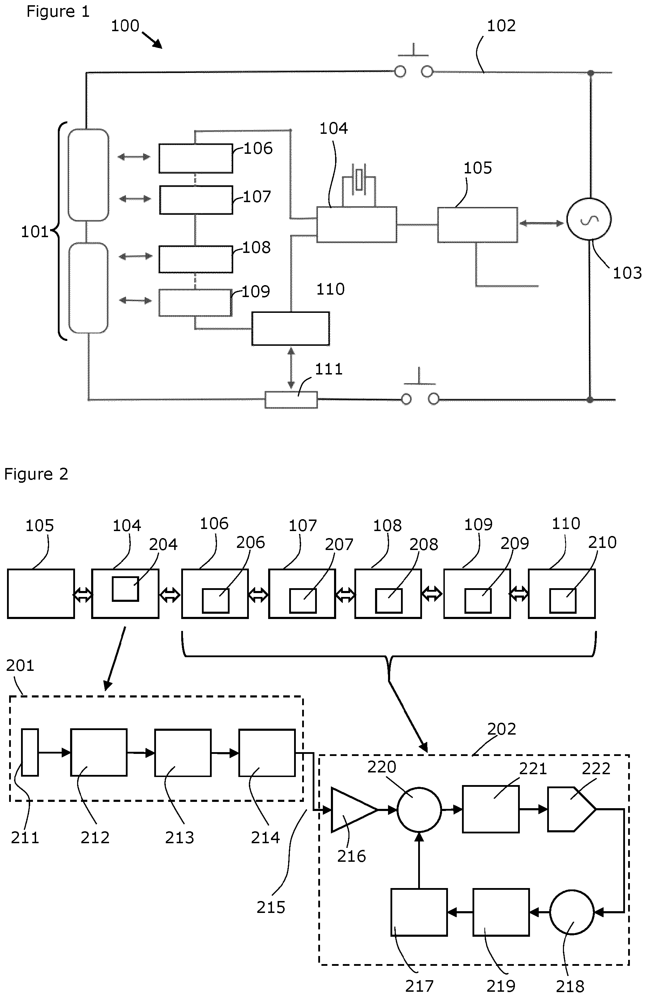

Figure 1 shows a battery management system 100. In this example, the battery management system 100 includes functionality to provide an electrochemical impedance measurement.

The battery management system 100 is configured to manage a plurality of battery cells 101, shown schematically in Figure 1. The battery cells 101 are coupled to an excitation circuit 102 which is configured to provide an excitation current and/or voltage by way of voltage source 103 for use in making of the electrochemical impedance measurement, as will be familiar to those skilled in the art.

In general, the battery management system 100 comprises a plurality of battery cell controllers or BCCs 106-109. The BCCs are each configured to measure the voltage of one or more cells. In the present example, the system 100 also include a battery junction box measurement system or BJBMS 110 configured to measure a current flow through the one or more battery cells 101. A shunt resistor 111 is shown to facilitate the current measurement by the BJBMS 110. The BCCs 106-109 and the BJBMS 110 are referred to, in the present disclosure, as measurement devices because they are configured to measure electrical properties of one or more battery cells.

The plurality of measurement devices 106-110 are connected in series to form a daisy-chain connected communication network with a gateway master device 104. The gateway master device 104 may be configured to communicate with the BCCs and BJBMS 106-110 by a first protocol, such as TPL protocol. In the present example, the communication network is configured such that the BCCs and BJBMS are galvanically isolated from one another, as will be familiar to those skilled in battery management systems. In other examples, the communication network may comprise a wireless communication network and/or may have a star topology.

The gateway master device 104 is also coupled to a microcontroller 105. In some examples, the gateway master device 104 is configured to communicate with the microcontroller 105 using a second, different protocol, such as SPI, although in other examples the same, first, protocol may be used.

Each measurement device 106-110 may include a local oscillator for keeping time. It is advantageous to synchronize the local oscillator with a master oscillator, which may be part of the gateway master device 104, the microcontroller 105 or part of another node.

Accordingly, we disclose a synchronisation element. In the present example, the synchronisation element comprises part of the gateway master device 104. However, in other examples, the synchronisation element may comprise part of the microcontroller 105. In some other examples, the synchronisation element may comprise part of the gateway master device 104 and its reference clock signal is derived from the output of an oscillator that is part of the microcontroller 105. In other examples, the synchronisation element comprises at least part of one or more of the BCCs or BJBMS. In general, the functionality of the synchronisation element may be provided by a node separate to the gateway 104, microcontroller 105 and measurement devices 106-110, or may be part of one or more of the gateway 104, microcontroller 105 and measurement devices 106-110.

The synchronisation element is provided for managing the advantageous synchronisation process described herein. The synchronisation element comprises the master oscillator for maintaining a master time reference. The master oscillator may be part of the same integrated circuit as the synchronisation element or the synchronisation element 104, 105 may be communicatively coupled with circuitry that includes the oscillator. The local oscillator of each measurement device 106-110 in the present embodiment comprises a frequency locked loop, configured to generate an individual clock signal.

Example figure 2 shows block diagram of the communication network including the microcontroller 105. The synchronization element comprises part of the gateway 104 in the present example and includes the oscillator 204. Each of the measurement devices 106-110 comprise the local oscillator or frequency locked loop 206-210. A box 201 shows example components of the synchronisation element. A box 202 shows example components of each of the measurement devices 106-110 that are associated with the synchronisation process described herein.

The box 201 shows an oscillator 211, comprising a crystal oscillator, coupled with an optional time reference divider 212. The time reference divider 212 may provide a reference clock signal used by the synchronization element. In the present example, the synchronization element includes a reference counter 213 that is configured to increment a value based on the reference clock signal. The value of the counter 213 is used for synchronisation although in other examples the reference clock signal may be used directly. It will be appreciated that the direction the counter counts is arbitrary and therefore in other examples, it may be configured to decrement the value. A first protocol block 214 provides for communication of the value of the counter 213 to the plurality of measurement devices 106-110 in accordance with the first protocol as part of the synchronisation process described below. Thus, the value of the free-running counter 213 is encoded into a first protocol frame and, in the present example, comprises the time reference signal.

To summarize the synchronisation process, the synchronisation element is configured to send, via the communication network, time reference signals to the plurality of measurement devices based on the reference clock signal or, in the present example, based on the current value of the counter 213, which is based on the reference clock signal. The synchronisation element may be configured to check the communication network is available, i.e. free, for sending each time reference signal, as will be described below.

The time reference signal will be received and forwarded from each measurement device 106-110 to the next through the daisy-chain connected communication network.

The box 202 shows the time reference signal being received at input 215 by each of the measurement devices 106-110. The measurement devices 106-110 include a synchronisation loop 220, 221, 222, 218, 219, 217. The measurement devices 106-110 may comprise an optional scaling element 216 to scale the value of the counter 213 present in the time reference signal. In the present example, the measurement devices 106-110 comprises a local counter 217, which is incremented by the output of the local oscillator 218, which may be frequency divided by an optional divider 219. The local oscillator 218 may comprise a voltage-controlled oscillator or VCO. As before, it will be appreciated that the direction the local counter counts is arbitrary and therefore in other examples, it may be configured to decrement the value, provided it corresponds to the count direction of the counter 213.

The frequency of the local oscillators 218, 204-210 may drift from the oscillator 211 for one or more reasons, such as temperature. A comparator 220 is configured to compare the value of the counter 213 present in the time reference signal and the value of the local counter 217. The output of the comparator 220 is provided to a proportional-integral controller 221 which is configured to control a DAC 222, which, in turn, controls the frequency of the VCO 218. Accordingly, the incrementing of the local counter 217 is adjusted leading to synchronisation.

Thus, each measurement device 106-110 is configured to compare, using comparator 220, each time reference signal (or value of the counter 213) to its individual clock signal (or value of the local counter 217) and, based on any detected difference, adjust its local oscillator 218. The adjustment of the local oscillator is configured to cause the synchronization of the individual clock signal with the reference clock signal by, in the present example, causing the value of the counters 213 and 217 to converge.

In a different example, the PI controller 221 may be configured to gate/modify the output (such as by decimator or other clock output modification element) of an oscillator that replaces the VCO 218, such as to remove some clock cycles, so that the frequency of the output of the oscillator is controlled. The modified output of the oscillator may then be provided to the local counter 217, if used. This different example embodiment may lead to an oscillator output that does not keep a constant duty cycle, but that may be permissible in some circumstances.

As mentioned above, the synchronisation element may be configured to, prior to sending each of the time reference signals to the plurality of measurement devices, determine whether the communication network is busy or free for sending the time reference signal.

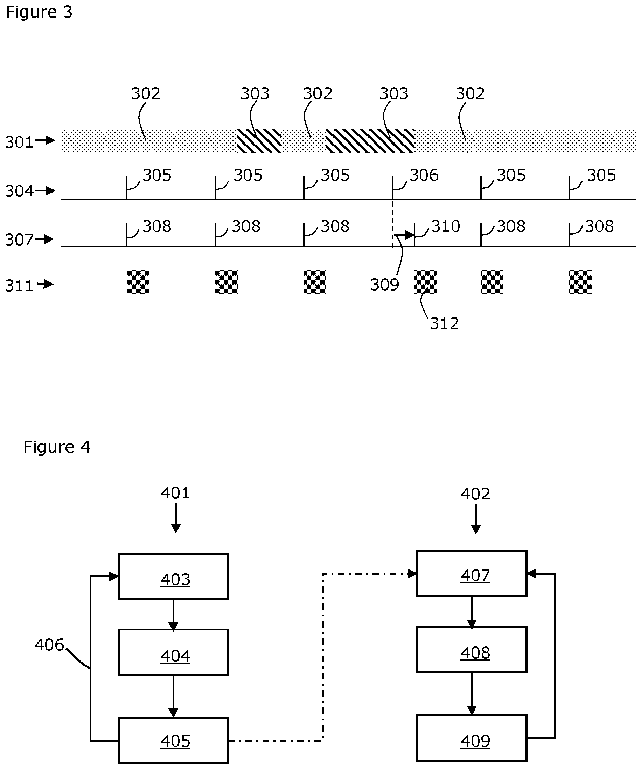

Figure 3 shows a timing diagram illustrating the sending of the time reference signals.

Time plot 301 illustrates when the communication network or daisy-chain bus is free or busy. The plot 301 includes free periods 302 and busy periods 303.

Time plot 304 illustrates the controller 105 providing a periodic trigger signal 305, 306 requesting the synchronisation element to initiate the sending of one of the time reference signals. Such a trigger signal 305, 306 is optional. In other examples, the synchronisation element may simply be programmed to send time-spaced or periodic time reference signals.

Time plot 307 illustrates the sending of the time reference signals.

During times when the communication network is free, such as when trigger signals 305 are generated, the synchronisation element is configured to send the time reference signal 308. However, time plot 307 also illustrates the action when a trigger signal 306 is generated when the communication channel is busy 303.

Thus, the synchronisation element receives the trigger signal 306 and determines that the communication network is busy 303 for sending the time reference signal. Accordingly, the synchronisation element is configured to wait 309 until the communication network is free 302 and send the time reference signal 310 based on the reference clock signal or counter 212 at the time the communication network becomes free.

Time plot 311 represents the time (or corresponding counter value) that the time reference signal is generated. When the communication network is free 302, the generation of the time reference signals temporally corresponds to the trigger signals 305. However, when the communication network is busy 303 the generation of the generation of the time reference signal 312 is delayed until the time the communication network is free (corresponding to the time of time reference signal 310).

Figure 4 shows a first flow chart 401 illustrating the actions of the synchronisation element and a second flow chart 402 illustrating the actions of the measurement devices 106-110.

Thus, with reference to the first and second flow charts 401, 402, at step 403, the synchronization element waits for the trigger signal from the microcontroller 105. At step 404, the synchronisation element is configured to determine if the communication network is free for sending the time reference signal 312. If the communication network is busy, it is configured to wait and send the time reference signal at a later time (e.g. time of 310 shown in Figure 3) based on the reference clock signal at the later time. However, if the communication network is free, the synchronisation element is configured to send the time reference signal based on the reference clock signal. Step 405 illustrates the sending of an instance of the time reference signal 312. The flowchart 401 then repeats, shown by arrow 406.

In the present example, the communication network is a single controller system, i.e. the controller sends requests (the time reference signal) and the targets respond. The synchronization element integrates easily into the communication network because, in the present example, the time reference signal uses the same first protocol that the gateway 104, BCCs 106-109 and BJBMS 110 use to communicate.

The step 404 may represent the synchronisation element 104 being configured to determine when the communication network or "channel" is free based, at least in part, on one or more first protocol rules. Thus, the synchronisation element 104 may be configured to determine if the communication network, such as a bus, is available and, if not available, it may determine, based on one or more first protocol rules, the time where the channel will be available, because the time the channel is not available has an upper bound. For instance, a read request command of the first protocol and the response, according to the rules of the first protocol, may be required to be completed within an upper bound time duration. The battery management system 100 or, more particularly in some examples, the synchronisation element 104 provided in the gateway, may be configured to calculate the maximum time where the communication network will be busy based on the first protocol rules. The calculation may be performed to prepare for the sending of the time reference signal or to determine the impact on the synchronization process of the channel being busy. Also, there may be other timing properties of the first protocol that allow the synchronisation element 104 to determine that all responses to a read request are received. Together with the fact that only the controller 105 can initiate communication (and BCCs and BJBMS only respond to requests coming from the controller), this allows the controller 105 and, by communication, the synchronisation element 104, to determine that the channel is free.

The dashed line represents the time reference signal being transmitted over the communication network to each of the plurality of measurement devices 106-110.

Step 407 represents the synchronisation functionality at each of the plurality of measurement devices 106-110 waiting for the time reference signal 312. Step 408 shows the comparison of the time reference signal to the respective individual clock signal. If there is any difference detected, step 409 represents the measurement devices 106-110 adjusting their local oscillator to synchronize the individual clock signal with the reference clock signal (or value of the local counter 217 to value of the counter 213). The ability of the synchronization element to wait for the channel to become free while effectively providing a time reference signal for synchronization is advantageous and it has been found that there is minimal additional overhead.

Thus, the synchronization element may be configured to determine if the communication network or "channel" is free for long enough to be able to send the time reference signal. The time reference signal, in the present example, is coded into the first communication protocol and transmitted as a regular communication frame, thereby not adding complexity.

Following step 409, the synchronization of each of the individual clock signals of each of the measurement devices with the reference clock signal may be achieved. Thus, the microcontroller 105 may be configured to provide for the excitation voltage/current and the plurality of measurement devices may be configured to, following said synchronization and excitation, measure the voltage/current of the battery cells for an electrochemical impedance measurement. The measurement devices 106-110 may be configured to send the measured voltage and/or current, or voltages and/or currents over time, to the microcontroller 105 over the communication network (or to any other node hosting the functionality for making the electrochemical impedance measurement).

While flow charts 401 and 402 show a more detailed method, in general, we also disclose a method for controlling a battery management system, wherein the method comprises:
sending 405, by the synchronisation element, time reference signals to the plurality of measurement devices 106-110 based on the reference clock signal;
comparing 408, by each measurement device, each time reference signal to the individual clock signal; and
adjusting 409, based on any detected difference, by each measurement device, its local oscillator to synchronize the individual clock signal with the reference clock signal.

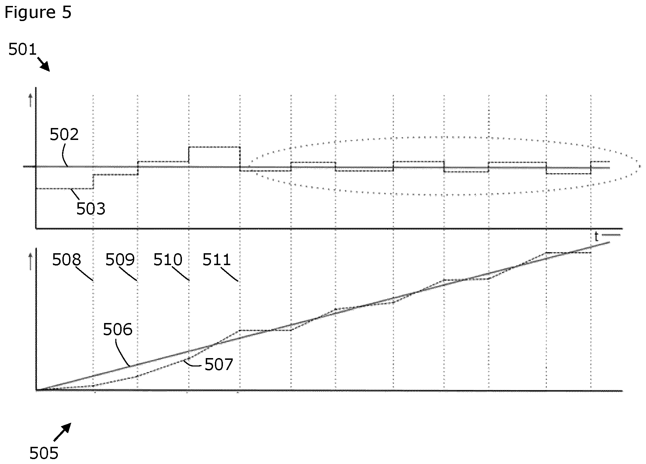

Figure 5 shows graphs illustrating the results of the synchronization process. Figure 5 shows a first graph 501 illustrating the frequency of the oscillator 204 as plot 502 and the frequency of one of the local oscillators 218 as plot 503 over time during the synchronisation process.

Second graph 505 shows the value of the counter 213 as plot 506 and the value of one of the local counters 217 as plot 507 over time during the synchronisation process.

Lines 508, 509, 510, 511 show the sending of one of the time reference signals. It will be appreciated that given the method includes waiting for the communication network to be free, the lines 508, 509, 510, 511 may not be equidistant.

It can be seen that the individual clock signal 503 based respectively on the frequency of each local oscillator 218 converges to match the reference clock signal 512, which is based on the frequency of the oscillator 211. Likewise, the value 507 of the local counter 217 converges to match the value 506 of the counter 213.

The instructions and/or flowchart steps in the above figures can be executed in any order, unless a specific order is explicitly stated. Also, those skilled in the art will recognize that while one example set of instructions/method has been discussed, the material in this specification can be combined in a variety of ways to yield other examples as well, and are to be understood within a context provided by this detailed description.

In some example embodiments the set of instructions/method steps described above are implemented as functional and software instructions embodied as a set of executable instructions which are effected on a computer or machine which is programmed with and controlled by said executable instructions. Such instructions are loaded for execution on a processor (such as one or more CPUs). The term processor includes microprocessors, microcontrollers, processor modules or subsystems (including one or more microprocessors or microcontrollers), or other control or computing devices. A processor can referto a single component or to plural components.

In other examples, the set of instructions/methods illustrated herein and data and instructions associated therewith are stored in respective storage devices, which are implemented as one or more non-transient machine or computer-readable or computer-usable storage media or mediums. Such computer-readable or computer usable storage medium or media is (are) considered to be part of an article (or article of manufacture). An article or article of manufacture can refer to any manufactured single component or multiple components. The non-transient machine or computer usable media or mediums as defined herein excludes signals, but such media or mediums may be capable of receiving and processing information from signals and/or other transient mediums.

Example embodiments of the material discussed in this specification can be implemented in whole or in part through network, computer, or data based devices and/or services. These may include cloud, internet, intranet, mobile, desktop, processor, look-up table, microcontroller, consumer equipment, infrastructure, or other enabling devices and services. As may be used herein and in the claims, the following non-exclusive definitions are provided.

In one example, one or more instructions or steps discussed herein are automated. The terms automated or automatically (and like variations thereof) mean controlled operation of an apparatus, system, and/or process using computers and/or mechanical/electrical devices without the necessity of human intervention, observation, effort and/or decision.

It will be appreciated that any components said to be coupled may be coupled or connected either directly or indirectly. In the case of indirect coupling, additional components may be located between the two components that are said to be coupled.

In this specification, example embodiments have been presented in terms of a selected set of details. However, a person of ordinary skill in the art would understand that many other example embodiments may be practiced which include a different selected set of these details. It is intended that the following claims cover all possible example embodiments.

## Claims

1. A battery management system comprising:
a synchronisation element comprising an oscillator wherein the synchronisation element is configured to generate a reference clock signal based on an output of the oscillator; and
a plurality of measurement devices wherein each measurement device is configured to measure an electrical property of one or more battery cells and comprises a local oscillator configured to generate an individual clock signal; and
wherein the plurality of measurement devices are connected in a communication network with the synchronisation element, and wherein:
the synchronisation element is configured to send, by the communication network, time reference signals to the plurality of measurement devices based on the reference clock signal;
each measurement device is configured to compare each time reference signal to its individual clock signal and, based on any detected difference, adjust its local oscillator to synchronize the individual clock signal with the reference clock signal.

2. The battery management system of claim 1, wherein the synchronisation element is configured to, prior to sending each of the time reference signals to the plurality of measurement devices, determine whether the communication network is busy or free for sending the time reference signal, and
if the communication network is free, send the time reference signal based on the reference clock signal;
if the communication network is busy, send the time reference signal at a later time based on the reference clock signal at the later time.

3. The battery management system of claim 1 or claim 2, wherein the synchronisation element is configured to, prior to sending each of the time reference signals to the plurality of measurement devices, determine whether the communication network is busy or free for sending the time reference signal, and
if the communication network is busy, wait until the communication network is free and send the time reference signal based on the reference clock signal at the time the communication network becomes free.

4. The battery management system of any preceding claim, wherein the synchronisation element comprises a counter configured to one of increment or decrement a value based on the reference clock signal and wherein each time reference signal is based on the current value of the counter.

5. The battery management system of any preceding claim, wherein the plurality of measurement devices are configured to, following said synchronization of the individual clock signal of each of the measurement devices with the reference clock signal, measure the voltage of the battery cells for an electrochemical impedance measurement.

6. The battery management system of any preceding claim, comprising a microcontroller communicatively coupled with a gateway master device, wherein the gateway master device comprises part of the communication network with the plurality of measurement devices.

7. The battery management system of claim 6, wherein the synchronisation element comprises part of the gateway master device.

8. The battery management system of any preceding claim, wherein the plurality of measurement devices and the gateway master device are configured to communicate over the communication network using a first protocol and wherein the time reference signals are sent using the first protocol.

9. The battery management system of claim 7, wherein the controller is configured to provide a periodic trigger signal to the synchronisation element to initiate the sending of one of the time reference signals; and
wherein the synchronisation element is configured to, in response to receipt of the trigger signal, and prior to sending each of the time reference signals to the plurality of measurement devices, determine whether the communication network is busy or free for sending the time reference signal; and
if the communication network is busy, wait until the communication network is free and send the time reference signal based on the reference clock signal at the time the communication network becomes free.

10. The battery management system of claim 6, wherein the synchronisation element comprises part of the microcontroller.

11. The battery management system of any preceding claim, wherein each of the local oscillators comprises a frequency locked loop.

12. The battery management system of claim 4, wherein the local oscillator of each of the plurality of measurement devices comprises a voltage-controlled oscillator and each of the plurality of measurement devices comprise:
a synchronisation loop comprising a comparator, a local counter configured to one of increment or decrement a respective second value based on an output of the local oscillator, and a proportional-integral controller, wherein the comparator is configured to compare the output of the local counter to the counter value indicated by the time reference signal and the proportional-integral controller is configured to, based on any detected difference, control the voltage provided to the voltage-controlled oscillator to adjust a frequency of the output of the voltage-controlled oscillator, the synchronisation loop configured to cause the frequency of the voltage-controlled oscillator to converge towards the frequency of the oscillator of the synchronisation element.

13. The battery management system of any preceding claim, wherein the plurality of measurement devices comprise one or both of:
a plurality of battery cell controllers configured to measure a voltage of one or more battery cells; and
a battery junction box measurement system configured to measure a current flow through one or more battery cells.

14. The battery management system of any preceding claim, wherein the communication network is configured to galvanically isolate the plurality of measurement devices from one another.

15. A method for controlling a battery management system, the battery management system comprising a synchronisation element comprising an oscillator wherein the synchronisation element is configured to generate a reference clock signal based on an output of the oscillator; and a plurality of measurement devices wherein each measurement device is configured to measure an electrical property of one or more battery cells and comprises a local oscillator configured to generate an individual clock signal; and wherein the plurality of measurement devices are connected to form a communication network with the synchronisation element, and wherein the method comprises:
sending, by the synchronisation element, time reference signals to the plurality of measurement devices based on the reference clock signal;
comparing, by each measurement device, each time reference signal to the individual clock signal; and
adjusting, based on any detected difference, by each measurement device, its local oscillator to synchronize the individual clock signal with the reference clock signal.
